# EUROPEAN PATENT APPLICATION

(11) **EP 4 708 398 A1**
(43) Date of publication of application: **11.03.2026**
(21) Application number: 24815945.1
(22) Date of filing: 03.06.2024
(51) Int. Cl.: H01M 4/525, H01M 4/04, C01G 53/00, H01M 10/052, C30B 29/22, H01M 4/02

(54) **POSITIVE ELECTRODE ACTIVE MATERIAL, METHOD FOR PRODUCING SAME, POSITIVE ELECTRODE COMPRISING POSITIVE ELECTRODE ACTIVE MATERIAL, AND LITHIUM SECONDARY BATTERY COMPRISING POSITIVE ELECTRODE ACTIVE MATERIAL**

(30) Priority: 02.06.2023 KR 20230071871
(71) Applicant: LG Chem, Ltd., Seoul 07336 (KR)
(72) Inventor: KIM, Jun Seong, Daejeon 34122 (KR); JU, Jin Wook, Daejeon 34122 (KR); JEONG, Myung Gi, Daejeon 34122 (KR); WOO, Sang Won, Daejeon 34122 (KR); LYM, Jae Seung, Daejeon 34122 (KR); KIM, Jeong Won, Daejeon 34122 (KR); JUNG, Jin Hee, Daejeon 34122 (KR); KIM, Sol Jin, Daejeon 34122 (KR); CHOE, Gwang Seok, Daejeon 34122 (KR)
(74) Representative: Hoffmann Eitle
(86) International application number: PCT/KR2024/007592
(87) International publication number: WO 2024/248571

(57) **Abstract**

The present invention relates to a positive electrode active material comprising a lithium transition metal oxide in a form of a single particle, wherein the lithium transition metal oxide contains 60 mol% or more of nickel among total transition metals, wherein, when a pressure of 6,500 kgf/cm² is applied to the positive electrode active material, an amount of fine powder having a particle diameter of 1 µm or less is 10 vol% or less based on a total volume of the positive electrode active material after the applying the pressure, a method for preparing the positive electrode active material, and a positive electrode and lithium secondary battery including the positive electrode active material.

## Description

### TECHNICAL FIELD

### Cross-reference to Related Applications

This application claims priority from Korean Patent Application No. 10-2023-0071871, filed on June 02, 2023, the disclosure of which is incorporated by reference herein.

### Technical Field

The present invention relates to a positive electrode active material, a method for preparing the positive electrode active material, and a positive electrode and lithium secondary battery including the positive electrode active material.

### BACKGROUND ART

Demand for secondary batteries as an energy source has been significantly increased as technology development and demand with respect to mobile devices have increased. Among these secondary batteries, lithium secondary batteries having high energy density, high discharge voltage, long cycle lifespan, and low self-discharge rate have been commercialized and widely used.

Lithium transition metal composite oxides have been used as a positive electrode active material of the lithium secondary battery, and, among these oxides, a lithium cobalt composite metal oxide, such as LiCoO₂, having a high operating voltage and excellent capacity characteristics has been mainly used. However, LiCoO₂ has poor thermal properties due to an unstable crystal structure caused by delithiation. Also, since LiCoO₂ is expensive, there is a limitation in using a large amount of LiCoO₂ as a power source for applications such as electric vehicles.

Lithium manganese composite metal oxides (LiMnO₂ or LiMn₂O₄), lithium iron phosphate compounds (LiFePO₄, etc.), or lithium nickel composite metal oxides (LiNiO₂, etc.) have been developed as materials for replacing LiCoO₂. Among these materials, research and development of the lithium nickel composite metal oxides, in which a large capacity battery may be easily achieved due to a high reversible capacity of about 200 mAh/g, have been more actively conducted. However, LiNiO₂ has limitations in that LiNiO₂ has poorer thermal stability than LiCoO₂, and, when internal short-circuit occurs in a charged state due to an external pressure, the positive electrode active material itself is decomposed to cause rupture and ignition of the battery. Accordingly, as a method to improve low thermal stability while maintaining the excellent reversible capacity of LiNiO₂, a lithium composite transition metal oxide, in which a portion of nickel (Ni) is substituted with cobalt (Co), manganese (Mn), or aluminum (Al), has been developed.

However, with respect to a lithium ion battery using this lithium transition metal oxide, particularly, a lithium transition metal oxide including a high content of nickel (Ni-rich) as a positive electrode active material, as a content of nickel increases, a large capacity may be achieved, but there is a disadvantage in that a rolling density of a particle is low.

In order to maximize volumetric energy density of a battery, a method of rolling a positive electrode active material layer using a roll press has been used to reduce voids between positive electrode active material particles so that the positive electrode active material layer having a denser structure may be prepared during manufacture of an electrode. However, when a cracking phenomenon of particles during the rolling occurs, a contact area with an electrolyte solution may be excessively increased to cause a side reaction with the electrolyte solution, and the broken positive electrode active material particle may block a path, through which the electrolyte solution is introduced into the positive electrode active material layer, or cause a decrease in conductivity.

Therefore, there is a need to develop a positive electrode material capable of improving the volumetric energy density and suppressing the particle cracking during the rolling for the manufacture of the positive electrode to improve life characteristics.

### [Prior Art Documents]

### [Patent Documents]

(Patent Document 1) KR 2021-0117212 A
(Patent Document 2) KR 10-2022-0048191 A
(Patent Document 3) KR 10-2022-0048192 A

### DISCLOSURE OF THE INVENTION

### TECHNICAL PROBLEM

An aspect of the present invention provides a positive electrode active material in which particle cracking is reduced during rolling.

An aspect of the present invention provides a method for preparing a positive electrode active material in which particle cracking is reduced during rolling.

### TECHNICAL SOLUTION

In order to solve the above-described tasks, the present invention provides a positive electrode active material, a method for preparing the positive electrode active material, and a positive electrode and lithium secondary battery including the positive electrode active material.
(1) The present invention provides a positive electrode active material comprising a lithium transition metal oxide in a form of a single particle, wherein the lithium transition metal oxide contains 60 mol% or more of nickel among total transition metals, wherein, when a pressure of 6,500 kgf/cm² is applied to the positive electrode active material, an amount of fine powder having a particle diameter of 1 µm or less is 10 vol% or less based on a total volume of the positive electrode active material after the applying the pressure.
(2) The present invention provides the positive electrode active material of (1) above, wherein the positive electrode active material has an average particle diameter (D₅₀) of 2 µm to 12 µm.
(3) The present invention provides the positive electrode active material of (1) or (2) above, wherein the positive electrode active material has a particle strength of 500 Mpa to 1,500 Mpa, wherein the particle strength (MPa) is a value which is obtained by collecting a sample of lithium transition metal oxide particles, placing the collected sample on glass, and then measuring a force until the particles break and a tip touches the glass on which the sample has been placed while applying a pressure of 100 mN to the sample with the tip.
(4) The present invention provides the positive electrode active material of any one of (1) to (3) above, wherein the positive electrode active material has a composition represented by Formula 1 below:

   [Formula 1] LiₐNiₓCo_{y}M¹_{z}M²_{1-x-y-z}O₂

   wherein, in Formula 1, M¹ is at least one selected from the group consisting of manganese (Mn) and aluminum (Al), M² is at least one selected from the group consisting of boron (B), barium (Ba), cerium (Ce), chromium (Cr), fluorine (F), magnesium (Mg), vanadium (V), titanium (Ti), iron (Fe), zirconium (Zr), zinc (Zn), silicon (Si), yttrium (Y), niobium (Nb), gallium (Ga), tin (Sn), molybdenum (Mo), tungsten (W), phosphorus (P), sulfur (S), strontium (Sr), tantalum (Ta), lanthanum (La), and hafnium (Hf), and 1.0≤a≤1.3, 0.6≤x<1.0, 0<y<0.4, 0<z<0.4, and 0≤1-x-y-z≤0.4.
(5) The present invention provides the positive electrode active material of any one of (1) to (4) above, wherein an amount of fine powder having a particle diameter of 1 µm or less before rolling is 0% to 1% based on a total number of the positive electrode active material.
(6) The present invention provides a method for preparing a positive electrode active material, the method comprising steps of: 1) preparing a pre-sintered product by mixing a positive electrode active material precursor containing 60 mol% or more of nickel among total transition metals, and a lithium-containing raw material, and increasing a temperature to a primary sintering temperature to perform primary sintering; 2) cooling the pre-sintered product to room temperature; and 3) preparing a lithium transition metal oxide in a form of a single particle by mixing the pre-sintered product and the lithium-containing raw material, and increasing the temperature to a secondary sintering temperature to perform secondary sintering, wherein the primary sintering temperature is 850°C to 950°C, the secondary sintering temperature is 800°C to 850°C, and the secondary sintering temperature is lower than the primary sintering temperature.
(7) The present invention provides the method of (6) above, wherein a heating rate in step 1) and a heating rate in step 3) are each 4 °C/min to 7 °C/min.
(8) The present invention provides the method of (6) or (7) above, further comprising a step of 2-1) grinding the pre-sintered product before the secondary sintering is performed in step 3).
(9) The present invention provides the method of any one of (6) to (8) above, further comprising a step of 3-1) grinding the secondary sintered product.
(10) The present invention provides a positive electrode comprising the positive electrode active material of any one of (1) to (5) above.
(11) The present invention provides a lithium secondary battery comprising: the positive electrode of (10) above; a negative electrode; a separator interposed between the positive electrode and the negative electrode; and an electrolyte.

### ADVANTAGEOUS EFFECTS

A positive electrode active material according to the present invention is a positive electrode active material including a lithium transition metal oxide in a form of a single particle, in which a content of nickel is 60 mol% or more based on the total number of moles of transition metals of the lithium transition metal oxide, where, when a pressure of 6,500 kgf/cm² is applied to the positive electrode active material, an amount of fine powder having a particle diameter of 1 µm or less is 10 vol% or less based on a total volume of the positive electrode active material after the applying the pressure. Thus, a cracking phenomenon of a lithium transition metal oxide particle may be effectively suppressed during rolling for manufacture of a positive electrode. Accordingly, in a case in which the positive electrode active material according to the present invention is used, a side reaction with an electrolyte solution occurring due to the cracking of the lithium transition metal oxide particle may be minimized, and excellent capacity characteristics and life characteristics may be achieved.

### BRIEF DESCRIPTION OF THE DRAWINGS

FIG. 1 is a scanning electron microscope (SEM) image of a positive electrode active material prepared in Example 1.
FIG. 2 is an SEM image of a positive electrode active material prepared in Comparative Example 1.
FIG. 3 is a graph of particle distributions before and after rolling of the positive electrode active material prepared in Example 1.
FIG. 4 is a graph of particle distributions before and after rolling of a positive electrode active material prepared in Example 2.
FIG. 5 is a graph of particle distributions before and after rolling of a positive electrode active material prepared in Example 3.
FIG. 6 is a graph of particle distributions before and after rolling of a positive electrode active material prepared in Example 4.
FIG. 7 is a graph of particle distributions before and after rolling of the positive electrode active material prepared in Comparative Example 1.
FIG. 8 is a graph of particle distributions before and after rolling of a positive electrode active material prepared in Comparative Example 2.
FIG. 9 is a graph of particle distributions before and after rolling of a positive electrode active material prepared in Comparative Example 3.
FIG. 10 is a graph of particle distributions before and after rolling of a positive electrode active material prepared in Comparative Example 4.
FIG. 11 is a graph of cycle-based capacities (mAh/g) of secondary batteries including the positive electrode active materials prepared in Examples and Comparative Examples.

### BEST MODE FOR CARRYING OUT THE INVENTION

Hereinafter, the present invention will be described in more detail.

It will be understood that words or terms used in the specification and claims shall not be interpreted as the meaning defined in commonly used dictionaries. It will be further understood that the words or terms should be interpreted as having a meaning that is consistent with their meaning in the context of the relevant art and the technical idea of the invention, based on the principle that an inventor may properly define the meaning of the words or terms to best explain the invention.

The term "primary particle" in the present invention refers to the smallest particle unit that is distinguished as one lump when a cross-section of a positive electrode active material is observed through a scanning electron microscope (SEM), and may be composed of one grain or a plurality of grains.

The term "secondary particle" in the present invention refers to a secondary structure formed by aggregation of a plurality of the primary particles. An average particle diameter of the secondary particle may be measured using a particle size analyzer.

In this specification, a "form of a single particle" is a concept in contrast to a form of a spherical secondary particle, which is formed by aggregation of tens to hundreds of primary particles that are prepared by a conventional method, and means a form composed of 50 or less primary particles. Specifically, the form of a single particle in the present invention may be a single particle composed of one primary particle, or may be in the form of a secondary particle in which 2 or more, 3 or more, 4 or more, 5 or more, or 10 or more, and 30 or less, 35 or less, 40 or less, 45 or less, or 50 or less primary particles are aggregated.

The term "average particle diameter (D₅₀)" in the present invention refers to a particle diameter at 50% of cumulative distribution of volume according to the particle diameter. After dispersing measurement target powder in a dispersion medium, the dispersion medium is introduced into a commercial laser diffraction particle size measurement instrument (e.g., S3500 by Microtrac), a particle size distribution is calculated by measuring a difference in diffraction patterns due to a particle size when particles pass through a laser beam, and the D₅₀ may be measured by calculating a particle diameter at 50% of the cumulative distribution of volume according to the particle diameter using the measurement instrument.

### Positive Electrode Active Material

A positive electrode active material of the present invention includes a lithium transition metal oxide in a form of a single particle. The lithium transition metal oxide contains 60 mol% or more of nickel among total transition metals, and when a pressure of 6,500 kgf/cm² is applied to the positive electrode active material, an amount of fine powder having a particle diameter of 1 µm or less is 10 vol% or less based on a total volume of the positive electrode active material after the applying the pressure.

The lithium transition metal oxide is in the form of a single particle composed of 50 or less primary particles. That is, the lithium transition metal oxide is a single particle or in the form of a single particle in which 2 to 50 particles are aggregated. Specifically, the lithium transition metal oxide may be in a form composed of 2 to 40 primary particles, 2 to 30 primary particles, 2 to 20 primary particles, and 2 to 10 primary particles, and preferably 2 to 10 primary particles. The form of the single particle is distinct from a secondary particle in which more than 50 primary particles are aggregated.

In a case in which the lithium transition metal oxide is in the form of a single particle, stability may be excellent. Thus, even when the pressure is applied to the positive electrode active material including the lithium transition metal oxide, the positive electrode active material may less break or crack to reduce a side reaction between the positive electrode active material and an electrolyte solution. Accordingly, durability against volume changes during charge and discharge of a battery may be improved to improve life characteristics. With respect to a lithium transition metal oxide which is a secondary particle, particle cracking easily occurs during an electrode rolling process, and, as a result, since a surface area of a positive electrode active material is increased, degradation of storage and life performance at high temperatures are intensified. Particularly, with respect to a lithium transition metal oxide including a high content of nickel, a problem of a particle cracking phenomenon during rolling for manufacture of a positive electrode occurs more, and, in this case, a side reaction between the lithium transition metal oxide and the electrolyte solution may be increased, and physical properties of a battery may be deteriorated.

The positive electrode active material of the present invention may have a high degree of single-particle formation to exhibit a high particle strength. When the positive electrode active material is used to manufacture a positive electrode, particle cracking may be suppressed even during the rolling, and thus the amount of the fine powder having a particle diameter of 1 µm or less may be low even at the high pressure of 6,500 kgf/cm². In this case, the cracking phenomenon of a lithium transition metal oxide particle during the rolling for the manufacture of the positive electrode may be effectively suppressed. Accordingly, the side reaction with the electrolyte solution occurring due to the cracking of the lithium transition metal oxide particle may be minimized, and excellent capacity characteristics and life characteristics may be achieved.

Specifically, when the pressure of 6,500 kgf/cm² is applied to the positive electrode active material, the amount of the fine powder having a particle diameter of 1 µm or less is 10 vol% or less, 9 vol% or less, 8 vol% or less, 7 vol% or less, 6 vol% or less, 5 vol% or less, 4 vol% or less, or 3 vol% or less, based on a total volume of the positive electrode active material after the applying the pressure.

When compared to a case in which, with respect to positive electrode active materials in which particle cracking is suppressed, determination on whether to suppress particle cracking is generally based on a rolling pressure of 650 kgf/cm², the pressure of 6,500 kgf/cm² corresponds to high levels of pressure.

As above, since a degree of crystallinity and a degree of single-particle formation are high, the positive electrode active material of the present invention may exhibit very excellent effects of reducing and suppressing the particle cracking during the rolling.

According to an embodiment of the present invention, the positive electrode active material may have an average particle diameter (D₅₀) of 2 µm or more, 3 µm or more, 4 µm or more, 5 µm or more, or 6 µm or more, and may be 7 µm or less, 8 µm or less, 9 µm or less, 10 µm or less, 11 µm or less, or 12 µm or less. In a case in which the average particle diameter is within the above range, electrode density may be adjusted, and energy density may be adjusted.

According to an embodiment of the present invention, the positive electrode active material may have a particle strength of 500 Mpa to 1,500 Mpa, and specifically, 500 Mpa or more, 600 Mpa or more, 700 Mpa or more, 800 Mpa or more, or 900 Mpa or more, and may be 1,000 Mpa or less, 1,100 Mpa or less, 1,200 Mpa or less, 1,300 Mpa or less, 1400 Mpa or less, or 1,500 Mpa or less. In the positive electrode material of the present invention as above, the particle cracking may be effectively reduced, and accordingly, when the positive electrode material is applied to a battery, excellent long-life characteristics may be exhibited. In the present specification, the particle strength (MPa) is a value which is obtained by collecting a sample of lithium transition metal oxide particles, placing the collected sample on glass, and then measuring a force until the particles break and a tip touches the glass on which the sample has been placed while applying a constant pressure (100 mN) to the sample with the tip.

The positive electrode active material includes the lithium transition metal oxide in which a molar ratio of nickel among the transition metals is 60% or more. Since the nickel-rich lithium transition metal oxide has large capacity per unit volume, excellent capacity characteristics may be achieved when it is applied to a battery.

Specifically, the positive electrode active material may have a composition represented by Formula 1 below.

[Formula 1] LiₐNiₓCo_{y}M¹_{z}M²_{1-x-y-z}O₂

In Formula 1,
M¹ is at least one selected from the group consisting of manganese (Mn) and aluminum (Al),
M² is at least one selected from the group consisting of boron (B), barium (Ba), cerium (Ce), chromium (Cr), fluorine (F), magnesium (Mg), vanadium (V), titanium (Ti), iron (Fe), zirconium (Zr), zinc (Zn), silicon (Si), yttrium (Y), niobium (Nb), gallium (Ga), tin (Sn), molybdenum (Mo), tungsten (W), phosphorus (P), sulfur (S), strontium (Sr), tantalum (Ta), lanthanum (La), and hafnium (Hf), and
1.0≤a≤1.3, 0.6≤x<1.0, 0<y<0.4, 0<z<0.4, and 0≤1-x-y-z≤0.4.
a represents a molar ratio of lithium in the lithium transition metal oxide, and may satisfy 1.0≤a≤1.3, particularly 1.0≤a≤1.25, and more particularly 1.0≤a≤1.20.
x represents a molar ratio of nickel among total transition metals, and may satisfy 0.6≤x<1.0, particularly 0.6≤x≤0.99 or 0.70≤x≤0.99, and more particularly 0.8≤x≤0.95. In a case in which the nickel content satisfies the above range, excellent capacity characteristics may be achieved.
y represents a molar ratio of cobalt among the total transition metals, and may satisfy 0<y<0.40, particularly 0≤y≤0.35, and more particularly 0.01≤y≤0.30.
z represents a molar ratio of M¹ among the total transition metals, and may satisfy 0<z<0.40, particularly 0≤z<0.35, and more particularly 0.01≤z≤0.30.
1-x-y-z represents a molar ratio of M² among the total transition metals, and may satisfy 0≤1-x-y-z≤0.4, particularly 0≤1-x-y-z≤0.35, and more particularly 0≤1-x-y-z≤0.30.

The positive electrode active material may further include, as necessary, a coating portion including at least one element (hereinafter referred to as a "coating element") selected from the group consisting of Co, Al, B, Ba, Ce, Cr, F, Mg, V, Ti, Fe, Zr, Zn, Si, Y, Nb, Ga, Sn, Mo, W, P, S, Sr, Ta, La, and Hf, on a surface of the lithium transition metal oxide. In a case in which the coating portion as above is included, contact between the lithium transition metal oxide and the electrolyte solution may be blocked, and thus dissolution of the transition metal and gas generation due to the side reaction with the electrolyte solution may be effectively suppressed.

The coating portion may be formed through a method of mixing the lithium transition metal oxide and a raw material including the coating element and then heat-treating the mixture at a temperature of 200°C to 800°C.

### Method for Preparing Positive Electrode Active Material

A method for preparing a positive electrode active material of the present invention includes steps of 1) preparing a pre-sintered product by mixing a positive electrode active material precursor containing 60 mol% or more of nickel among total transition metals, and a lithium-containing raw material, and increasing a temperature to a primary sintering temperature to perform primary sintering, 2) cooling the pre-sintered product to room temperature, and 3) preparing a lithium transition metal oxide in a form of a single particle by mixing the pre-sintered product and the lithium-containing raw material, and increasing the temperature to a secondary sintering temperature to perform secondary sintering, the primary sintering temperature being 850°C to 950°C, the secondary sintering temperature being 800°C to 850°C, and the secondary sintering temperature being lower than the primary sintering temperature.

The positive electrode active material prepared by the method for preparing the positive electrode active material according to the present invention has characteristics that a degree of crystallinity and a degree of single-particle formation are high. Accordingly, the positive electrode active material has a high rolling strength and a low generation rate of fine powder where, when a pressure of 6,500 kgf/cm² is applied to the positive electrode active material, an amount of fine powder having a particle diameter of 1 µm or less in the positive electrode active material is 10 vol% or less, i.e., the amount of the fine powder having a particle diameter of 1 µm or less is 10 vol% or less based on a total volume of the positive electrode active material after the applying the pressure.

When a mixture of the positive electrode active material precursor containing 60 mol% or more of nickel among the total transition metals, and the lithium-containing raw material is primarily sintered at the temperature of 850°C to 950°C, the pre-sintered product in the form of a single particle is prepared while primary particles of the positive electrode active material precursor are aggregated.

The positive electrode active material precursor containing 60 mol% or more of nickel among the total transition metals may be, specifically, a positive electrode active material precursor containing nickel (Ni), cobalt (Co), and manganese (Mn) and also containing 60 mol% or more of nickel among the total transition metals.

The primary sintering temperature may be, specifically, 850°C or more, 860°C or more, 870°C or more, 880°C or more, 900°C or more, or 910°C or more, and 930°C or less, 940°C or less, or 950°C or less. In a case in which the primary sintering temperature is within the above range, a structurally stable pre-sintered product in the form of a single particle may be formed while the primary particles of the positive electrode active material precursor are aggregated. In a case in which the primary sintering temperature is lower than 850°C, the primary particles may not be sufficiently aggregated, and in a case in which the primary sintering temperature is higher than 950°C, there is a problem in that a structurally unstable sintered product with a low degree of crystallinity is prepared.

The primary sintering may be performed in an oxygen atmosphere, in terms of preventing degradation of the lithium transition metal oxide into a rock salt structure.

In order to aggregate the primary particles and improve crystallinity of the pre-sintered product, the primary sintering may be performed for 3 hours or more, 4 hours or more, 5 hours or more, or 6 hours or more, and 10 hours or less, 11 hours or less, or 12 hours or less.

According to an embodiment of the present invention, a heating rate in step 1) may be 4 °C/min to 7 °C/min, and specifically, may be 4 °C/min or more, or 5 °C/min or more, and 7 °C/min or less. In a case in which, in the primary sintering, the heating rate satisfies the above range, the structurally more stable pre-sintered product in the form of a single particle may be formed while the primary particles of the positive electrode active material precursor are aggregated, and an amount of fine powder having a particle diameter of 1 µm or less may be minimized in a finally prepared positive electrode active material. In a case in which, in the primary sintering, the heating rate is more than 7 °C/min, the primary particles may not be sufficiently aggregated to increase the amount of fine powder having a particle diameter of 1 µm or less in the finally prepared positive electrode active material. In a case in which, in the primary sintering, the heating rate is less than 4 °C/min, the entire primary sintering may take more time than is necessary.

When the pre-sintered product is obtained, the lithium transition metal oxide in the form of a single particle may be prepared by cooling the pre-sintered product to room temperature, mixing the pre-sintered product and the lithium-containing raw material, and increasing the temperature to the secondary sintering temperature to perform the secondary sintering.

When the pre-sintered product is secondarily sintered at the temperature of 800°C to 850°C, a secondary sintered product is prepared while lithium is intercalated into the primary sintered product. Here, the secondary sintered product is the lithium transition metal oxide in the form of a single particle. The secondary sintering temperature may be, specifically, 800°C or more, 810°C or more, 820°C or more, or 830°C or more, and 840°C or less, or 850°C or less. In a case in which the secondary sintering temperature is within the above range, there are advantages in that a layered structure is restored while lithium is intercalated into a rock salt structure which may be formed on a surface of the pre-sintered product due to the high temperature during the primary sintering and a lithium by-product is reduced. In a case in which the secondary sintering temperature is lower than 800°C, a lithium intercalation rate may be low due to the low temperature, and, in a case in which the secondary sintering temperature is higher than 850°C, the surface of the pre-sintered product may degrade into the rock salt structure due to the high temperature, and the lithium by-product may remain.

The secondary sintering may be performed in an oxygen atmosphere, in terms of preventing the degradation of the lithium transition metal oxide into the rock salt structure.

The secondary sintering may be performed for 3 hours or more, 4 hours or more, 5 hours or more, or 6 hours or more, and 10 hours or less, 11 hours or less, or 12 hours or less, in terms of increasing a degree of crystallinity of the internal crystal structure of the positive electrode active material.

Also, a heating rate of the secondary sintering in step 3) may be 4 °C/min to 7 °C/min, and specifically, may be 4 °C/min or more, or 5 °C/min or more, and 7 °C/min or less. In a case in which the heating rate of the secondary sintering satisfies the above range, the layered structure may be restored while lithium is more effectively intercalated into the rock salt structure which may be formed on the surface of the pre-sintered product, and the lithium by-product may be further reduced. In a case in which the heating rate of the secondary sintering is too high, it may be difficult to obtain the same effects as those when the appropriate heating rate is satisfied, and due to an insufficient increase in a degree of crystallinity of the finally prepared positive electrode active material, the amount of the fine powder having a particle diameter of 1 µm or less may be increased in the positive electrode active material after the rolling. In a case in which the heating rate of the secondary sintering is lower than the above range, the entire secondary sintering may take more time than is necessary.

According to an embodiment of the present invention, a step of 2-1) grinding the pre-sintered product may be further included before the pre-sintered product having been cooled to room temperature in step 2) is secondarily sintered in step 3). In step 2-1), the pre-sintered product may be ground such that an average particle diameter (D₅₀) is in a range of 3.50 µm to 6.00 µm, in terms of preventing an increase in initial resistance.

According to an embodiment of the present invention, a step of 3-1) grinding the secondary sintered product may be further included. Also in step 3-1), the secondary sintered product may be ground such that an average particle diameter (D₅₀) is in a range of 3.50 µm to 6.00 µm, in terms of preventing an increase in initial resistance.

The grinding in steps 2-1) and 3-1) may be performed using a pin mill, an air classifying mill (ACM), a jet mill, or the like. With respect to the pin mill, milling may be performed at 18,000 rpm, with respect to the ACM, classification may be performed at 6,000 rpm and milling may be performed at 12,000 rpm using equipment by Hosokawa, and, with respect to the jet mill, classification may be performed at 3,500 rpm and milling may be performed at a pressure of 6 bars using equipment by ZM solution. In this case, the positive electrode active material having a desired average particle diameter (D₅₀) may be easily obtained.

According to an embodiment of the present invention, the positive electrode active material may be prepared through a process of adding the lithium-containing raw material in two portions. That is, the lithium-containing raw material is dividedly added before the primary sintering and before the secondary sintering, respectively. In this case, there is an advantage in that the intercalation of lithium into the rock salt structure, which may be formed on the surface, favors the restoration of the layered structure. In a case in which the lithium-containing raw material is added at once before the primary sintering, there is a problem of electrochemical performance degradation due to an increase in lithium by-product, and, when the lithium-containing raw material is not added in the secondary sintering, a problem occurs which requires high temperature and long time due to a low reaction rate.

In a case in which the lithium-containing raw material is added in two portions, in step 1), a first lithium-containing raw material may be mixed such that a ratio (M:Li) of the total number of moles (M) of transition metals included in the positive electrode active material precursor to the number of moles (Li) of lithium included in the first lithium-containing raw material is 1:0.98, 1:0.99, 1:1.00, 1:1.01, or 1:1.02 or more, and 1:1.04, or 1:1.05 or less, and, in step 3), a second lithium-containing raw material may be mixed such that a ratio (M':Li) of the total number of moles (M') of transition metals included in the primary sintered product to the total number of moles (Li) of lithium included in the primary sintered product is 1:0.01, or 1:1.05 or more, and 1:1.06, 1:1.07, 1:1.08, 1:1.09, or 1:1.10 or less.

According to an embodiment of the present invention, the method may further include a step of 4) mixing the lithium transition metal oxide and a cobalt-containing raw material and then performing a heat treatment. In this case, a coating portion containing Co is formed on the lithium transition metal oxide in the form of a single particle.

According to an embodiment of the present invention, when mixing the lithium transition metal oxide and the cobalt-containing coating raw material in step 4), an aluminum-containing raw material, a zirconium-containing raw material, or a combination thereof may be further mixed. In this case, the coating portion may further include Al, Zr, or a combination thereof in addition to Co.

According to an embodiment of the present invention, the cobalt-containing raw material may be mixed in an amount such that a ratio (B/A) of the number of moles (B) of cobalt contained in the cobalt-containing raw material to the total number of moles (A) of metals excluding lithium, which are included in the lithium transition metal oxide, is in a range of 0.01 to 0.03. In this case, there is an advantage in that the lithium by-product may be controlled in a positive electrode active material preparation process that does not include a washing process.

According to an embodiment of the present invention, the cobalt-containing raw material may be at least one selected from Co(OH)₂, Co₃O₄, CoO, (CH₃CO₂)₂Co, CoCl₂, and CoSO₄·xH₂O, and specifically, may be Co(OH)₂.

According to an embodiment of the present invention, the aluminum-containing raw material may be mixed in an amount of 0.03 part by weight to 0.10 part by weight based on 100 parts by weight of the lithium transition metal oxide. In this case, lifespan, resistance, and gas generation amount may be improved by ensuring the structural stability.

The aluminum-containing raw material may be at least one selected from Al(OH)₃, Al₂(SO₄)₃·xH₂O, Al₂O₃, Al(NO₃)₃·9H₂O, AlCl₃, and C₂H₅O₄Al, and specifically, may be Al(OH)₃.

The zirconium-containing raw material may be at least one selected from Zr(OH)₄, ZrO₂, Zr(NO₃)₄, ZrCl₄, ZrS₂, Zr(SO₄)₂, and C₈H₁₂O₈Zr.

According to an embodiment of the present invention, the heat treatment may be performed in an oxygen atmosphere to prevent the degradation of the lithium composite transition metal oxide into the rock salt structure.

According to the present invention, in order to form the coating portion to have an appropriate thickness, the heat treatment may be performed such that, after primary heat treatment is performed at a temperature of 600°C or more, 610°C or more, 620°C or more, 630°C or more, 640°C or more, or 650°C or more, and 720°C or less, 740°C or less, 760°C or less, 780°C or less, or 800°C or less, and secondary heat treatment is performed at a temperature of 450°C or more, 460°C or more, 470°C or more, or 480°C or more, and 520°C or less, 530°C or less, 540°C or less, or 550°C or less. That is, in one sintering profile, the heat treatment may be performed at the temperature of 600°C to 800°C, and then the heat treatment may be performed at the temperature of 450°C to 550°C.

According to the present invention, the heat treatment may be performed for 1 hour or more, 2 hours or more, or 3 hours or more, and 9 hours or less, 10 hours or less, 11 hours or less, or 12 hours or less, in order to increase a degree of crystallinity of the coating portion.

### Positive Electrode

Also, the present invention provides a positive electrode for a lithium secondary battery, the positive electrode including a positive electrode active material layer including the positive electrode active material. Specifically, the positive electrode includes a positive electrode current collector, and the positive electrode active material layer which is disposed on at least one surface of the positive electrode current collector and includes the positive electrode active material. The positive electrode active material layer may have a porosity of 10 vol% to 30 vol%, particularly 15 vol% to 30 vol%, and more particularly 18 vol% to 27 vol%.

When the positive electrode active material layer has the porosity, the positive electrode may include 50% or less of particles having a particle diameter of less than 1 µm based on the total number of particles in the positive electrode active material layer in measurement particle size distribution (PSD).

The positive electrode may include the particles having a particle diameter of less than 1 µm in an amount of, particularly, 0.01% to 50%, 0.05% to 30%, 0.1% to 28%, 0.05% to 27.5%, 0.1% to 27.5%, 0.05% to 15%, or 0.1% to 15% based on the total number of the positive electrode active material particles.

Since the particle cracking of the positive electrode material is reduced, the positive electrode may include only a small amount of fine powder having a particle diameter of less than 1 µm within the above range even when the positive electrode active material layer is rolled to have porosity within the above range during the manufacture of the positive electrode.

After the positive electrode active material layer including the positive electrode active material is formed and then rolled to have the porosity of 10 vol% to 30 vol%, particularly 15 vol% to 30 vol%, and more particularly 18 vol% to 24 vol%, the number of the particles having a particle diameter of less than 1 µm may be obtained by measuring the number of particles located in the positive electrode active material layer when the positive electrode active material layer is heat-treated for 2 hours in an air atmosphere at a temperature of 500°C.

The number of the particles having a particle diameter of less than 1 µm may be a ratio of the number when the total number of the positive electrode active material particles included in the positive electrode active material layer is defined as 100%, and specifically, may be obtained by measuring PSD using "MICROTRAC S3500" by MICROTRAC, "CILAS920, France" by CILAS, or "Mastersizer2000, USA" by MALVERN, and then dividing an area of the particles having a particle diameter of less than 1 µm by a total area in a PSD graph.

The positive electrode current collector is not particularly limited as long as having conductivity without causing chemical changes in the battery, and, for example, stainless steel, aluminum, nickel, titanium, fired carbon, or aluminum or stainless steel that is surface-treated with one of carbon, nickel, titanium, silver, or the like may be used. Also, the positive electrode current collector may generally have a thickness of 3 µm to 500 µm, and microscopic irregularities may be formed on a surface of the current collector to increase adhesion of the positive electrode active material. The positive electrode current collector may be used in various shapes, for example, a film, a sheet, a foil, a net, a porous body, a foam body, a non-woven fabric body, and the like.

The positive electrode active material layer may include a conductive agent and a binder in addition to the above-described positive electrode material according to the present invention.

The positive electrode active material may be included in an amount of 80 wt% to 99 wt%, more particularly, 85 wt% to 98 wt% based on a total weight of the positive electrode active material layer. When the positive electrode active material is included in the foregoing amount range, excellent capacity characteristics may be exhibited.

The conductive agent is used to provide conductivity to the electrode, and any conductive agent may be used without particular limitation as long as having electron conductivity without causing chemical changes in the provided battery. As a specific example, the conductive agent may be graphite such as natural graphite or artificial graphite, a carbon-based material such as carbon black, acetylene black, Ketjen black, channel black, furnace black, lamp black, thermal black, and carbon fibers, powder or fibers of a metal such as copper, nickel, aluminum, or silver, a conductive whisker such as zinc oxide whisker and potassium titanate whisker, conductive metal oxides such as titanium oxide, or a conductive polymer such as polyphenylene derivative, and any one thereof or a mixture of two or more thereof may be used. The conductive agent may be generally included in an amount of 1 wt% to 30 wt% based on the total weight of the positive electrode active material layer.

The binder serves to improve attachment between the positive electrode active material particles and adhesion between the positive electrode active material and the current collector. As a specific example, the binder may be polyvinylidene fluoride (PVDF), polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene monomer (EPDM), a sulfonated EPDM, a styrene-butadiene rubber (SBR), a fluorine rubber, or various copolymers thereof, and any one thereof or a mixture of two or more thereof may be used. The binder may be included in an amount of 1 wt% to 30 wt% based on the total weight of the positive electrode active material layer.

The positive electrode may be manufactured according to a general method for manufacturing a positive electrode except that the positive electrode active material according to the present invention is used. Specifically, a composition for forming the positive electrode active material layer, which is prepared by dissolving or dispersing, in a solvent, the above-described positive electrode active material as well as optionally the binder, the conductive agent, and an additive, if necessary, may be applied onto the positive electrode current collector, and then undergone drying and rolling to manufacture the positive electrode. Here, types and amounts of the positive electrode active material, the binder, and the conductive agent are the same as those described above.

The solvent may be a solvent normally used in this technical field. The solvent may include dimethyl sulfoxide (DMSO), isopropyl alcohol, N-methylpyrrolidone (NMP), acetone, water, or the like, and any one thereof or a mixture of two or more thereof may be used. An amount of the solvent used may be sufficient if the solvent may dissolve or disperse the positive electrode active material, the conductive agent, and the binder in consideration of a coating thickness of a slurry and manufacturing yield, and allow to have a viscosity that may provide excellent thickness uniformity during the subsequent coating for the manufacture of the positive electrode.

Also, as another method, the positive electrode may be manufactured by casting the composition for forming the positive electrode active material layer on a separate support and then laminating a film separated from the support on the positive electrode current collector.

### Lithium Secondary Battery

Also, in the present invention, an electrochemical device including the above positive electrode may be manufactured. The electrochemical device may be, specifically, a battery, a capacitor, or the like, and more specifically, may be a lithium secondary battery.

The lithium secondary battery specifically includes a positive electrode, a negative electrode disposed to oppose the positive electrode, and a separator and an electrolyte which are interposed between the positive electrode and the negative electrode. The positive electrode is the same as that described above and thus will not be specifically described, and only the remaining components will be specifically described below.

The lithium secondary battery may further optionally include a battery container which accommodates an electrode assembly of the positive electrode, the negative electrode, and the separator, and a sealing member which seals the battery container.

In the lithium secondary battery, the negative electrode includes a negative electrode current collector and a negative electrode active material layer disposed on the negative electrode current collector.

The negative electrode current collector is not particularly limited as long as having high conductivity without causing chemical changes in the battery, and, for example, copper, stainless steel, aluminum, nickel, titanium, fired carbon, copper or stainless steel, which is surface-treated with one of carbon, nickel, titanium, silver, or the like, an aluminum-cadmium alloy and the like may be used. Also, the negative electrode current collector may generally have a thickness of 3 µm to 500 µm, and, like the positive electrode current collector, the microscopic irregularities may be formed on a surface of the current collector to improve adhesion of the negative electrode active material. The negative electrode current collector may be used in various shapes, for example, a film, a sheet, a foil, a net, a porous body, a foam body, a non-woven fabric body, and the like.

The negative electrode active material layer optionally includes a binder and a conductive agent in addition to the negative electrode active material.

A compound capable of reversibly intercalating and deintercalating lithium may be used as the negative electrode active material. As a specific example, the negative electrode active material may be a carbonaceous material such as artificial graphite, natural graphite, graphitized carbon fibers, and amorphous carbon, a metallic compound alloyable with lithium such as silicon (Si), aluminum (Al), tin (Sn), lead (Pb), zinc (Zn), bismuth (Bi), indium (In), magnesium (Mg), gallium (Ga), cadmium (Cd), a Si alloy, a Sn alloy, or an Al alloy, a metal oxide which may be doped and undoped with lithium such as SiO_{β}(0<β<2), SnO₂, vanadium oxide, and lithium vanadium oxide, or a composite such as a Si-C composite or a Sn-C composite including the metallic compound and the carbonaceous material, and any one thereof or a mixture of two or more thereof may be used. Also, a metallic lithium thin film may be used as the negative electrode active material. Furthermore, both low crystalline carbon and high crystalline carbon may be used as the carbon material. Typical examples of the low crystalline carbon include soft carbon and hard carbon, and typical examples of the high crystalline carbon include irregular, planar, flaky, spherical, or fibrous natural graphite or artificial graphite, Kish graphite, pyrolytic carbon, mesophase pitch-based carbon fibers, meso-carbon microbeads, mesophase pitches, and high temperature sintered carbon such as petroleum or coal tar pitch derived cokes.

The negative electrode active material may be included in an amount of 80 parts by weight to 99 parts by weight based on 100 parts by weight of a total weight of the negative electrode active material layer.

The binder is a component that assists in the binding between the conductive agent, the active material, and the current collector, and is generally added in an amount of 0.1 part by weight to 10 parts by weight based on 100 parts by weight of the total weight of the negative electrode active material layer. Examples of this binder may include polyvinylidene fluoride (PVDF), polyvinyl alcohol, carboxymethylcellulose (CMC), starch, hydroxypropylcellulose, regenerated cellulose, polyvinylpyrrolidone, tetrafluoroethylene, polyethylene, polypropylene, an ethylene-propylene-diene polymer (EPDM), a sulfonated-EPDM, a styrene-butadiene rubber, a nitrile-butadiene rubber, a fluoro rubber, various copolymers thereof, and the like.

The conductive agent is a component for further improving conductivity of the negative electrode active material, and may be added in an amount of 10 parts by weight or less, preferably 5 parts by weight or less based on 100 parts by weight of the total weight of the negative electrode active material layer. The conductive agent is not particularly limited as long as having conductivity without causing chemical changes in this battery, and, for example, a conductive material such as graphite such as natural graphite or artificial graphite, carbon black such as acetylene black, Ketjen black, channel black, furnace black, lamp black, and thermal black, conductive fibers such as carbon fibers or metal fibers, metal powder such as fluorocarbon powder, aluminum powder, and nickel powder, conductive whiskers such as zinc oxide whiskers and potassium titanate whiskers, conductive metal oxide such as titanium oxide, polyphenylene derivatives, or the like may be used.

For example, the negative electrode active material layer may be manufactured by applying a negative electrode material mixture, which is prepared by dissolving or dispersing the negative electrode active material and optionally the binder and the conductive agent in a solvent, onto the negative electrode current collector, followed by drying, or the negative electrode active material layer may be manufactured by casting the negative electrode material mixture on a separate support and then laminating a film separated from the support on the negative electrode current collector.

In the lithium secondary battery, the separator separates the negative electrode and the positive electrode and provides a movement path of lithium ions, and any separator may be used as the separator without particular limitation as long as being generally used in the lithium secondary battery. And particularly, a separator having good moisture-retention ability for an electrolyte solution as well as low resistance to the ion transfer of electrolyte may be used. Specifically, a porous polymer film, for example, a porous polymer film prepared from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. Also, a general porous nonwoven fabric, for example, a nonwoven fabric formed of high melting point glass fibers or polyethylene terephthalate fibers may be used. Alternatively, a coated separator including a ceramic component or a polymer material may be used to secure heat resistance or mechanical strength, and the separator having a single-layer or multilayer structure may be optionally used.

Also, the electrolyte used in the present invention may include an organic liquid electrolyte, an inorganic liquid electrolyte, a solid polymer electrolyte, a gel-type polymer electrolyte, a solid inorganic electrolyte, a molten-type inorganic electrolyte, or the like which may be used in the manufacture of the lithium secondary battery, but the present invention is not limited thereto.

Specifically, the electrolyte may include an organic solvent and a lithium salt.

Any organic solvent may be used as the organic solvent without particular limitation so long as it may function as a medium through which ions involved in an electrochemical reaction of the battery may move. Specifically, an ester-based solvent such as methyl acetate, ethyl acetate, γ-butyrolactone, and ε-caprolactone, an ether-based solvent such as dibutyl ether or tetrahydrofuran, a ketone-based solvent such as cyclohexanone, an aromatic hydrocarbon-based solvent such as benzene and fluorobenzene, a carbonate-based solvent such as dimethyl carbonate (DMC), diethyl carbonate (DEC), methylethyl carbonate (MEC), ethylmethyl carbonate (EMC), ethylene carbonate (EC), and propylene carbonate (PC), an alcohol-based solvent such as ethyl alcohol and isopropyl alcohol, nitriles such as R-CN (where R is a linear, branched, or cyclic C2-C20 hydrocarbon group and may include a double-bond aromatic ring or ether bond), amides such as dimethylformamide, dioxolanes such as 1,3-dioxolane, or sulfolanes may be used as the organic solvent. Among these solvents, the carbonate-based solvent is preferable, and a mixture of a cyclic carbonate (e.g., ethylene carbonate or propylene carbonate) having high ionic conductivity and high dielectric constant, which may increase charge/discharge performance of the battery, and a low-viscosity linear carbonate-based compound (e.g., ethylmethyl carbonate, dimethyl carbonate, or diethyl carbonate) is more preferable. In this case, the performance of the electrolyte solution may be excellent when the cyclic carbonate and the chain carbonate are mixed in a volume ratio of about 1:1 to about 1:9.

The lithium salt may be used without particular limitation as long as the lithium salt is a compound capable of providing lithium ions used in the lithium secondary battery. Specifically, LiPF₆, LiClO₄, LiAsF₆, LiBF₄, LiSbF₆, LiAlO₄, LiAlCl₄, LiCF₃SO₃, LiC₄F₉SO₃, LiN (C₂F₅SO₃)₂, LiN(C₂F₅SO₂)₂, LiN(CF₃SO₂)₂. LiCl, LiI, LiB(C₂O₄)₂, or the like may be used as the lithium salt. The lithium salt may be used in a range of a concentration of 0.1 M to 2.0 M. In a case in which the concentration of the lithium salt is included within the above range, the electrolyte may have appropriate conductivity and viscosity. Thus, excellent performance of the electrolyte may be exhibited and lithium ions may effectively move.

In order to improve life characteristics of the battery, suppress a reduction in battery capacity, and improve discharge capacity of the battery, at least one additive, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte in addition to the electrolyte components. Here, the additive may be included in an amount of 0.1 part by weight to 5 parts by weight based on 100 parts by weight of a total weight of the electrolyte.

As described above, since the lithium secondary battery including the positive electrode active material according to the present invention stably exhibits excellent discharge capacity, output characteristics, and life characteristics, the lithium secondary battery is suitable for portable devices, such as mobile phones, notebook computers, and digital cameras, and electric vehicles such as hybrid electric vehicles (HEVs).

Accordingly, according to another embodiment of the present invention, a battery module including the lithium secondary battery as a unit cell, and a battery pack including the battery module are provided.

The battery module or the battery pack may be used as a power source of at least one medium and large sized device of a power tool, electric vehicles including an electric vehicle (EV), a hybrid electric vehicle, and a plug-in hybrid electric vehicle (PHEV), or a power storage system.

An outer shape of the lithium secondary battery according to the present invention is not particularly limited, but a cylindrical type using a can, a prismatic type, a pouch type, a coin type, or the like may be used.

The lithium secondary battery according to the present invention may be used in a battery cell that is used as a power source of a small device, and also, may be used as a unit cell in a medium and large sized battery module including a plurality of battery cells.

### MODE FOR CARRYING OUT THE INVENTION

Hereinafter, the present invention will be described in detail according to specific examples. The present invention may, however, be embodied in many different forms and should not be construed as being limited to the embodiments set forth herein. Rather, these embodiments of the present invention are provided so that this description will be thorough and complete, and will fully convey the scope of the present invention to those skilled in the art.

### Examples and Comparative Examples

### Example 1

A positive electrode active material precursor [composition: Ni_{0.85}Co_{0.05}Mn_{0.10}(OH)₂, average particle diameter (D₅₀) : 4.0 µm] and LiOH were mixed in a molar ratio of 1:1.04, and a temperature was increased at a heating rate of 5°C/min to perform primary sintering at a temperature of 910°C for 10 hours in an oxygen atmosphere, thereby preparing a pre-sintered product. Then, the pre-sintered product was cooled to room temperature.

The pre-sintered product was ground using an air jet mill, and then 0.01 mol of LiOH was further added. Then, the temperature was increased at the heating rate of 5°C/min to perform secondary sintering at a temperature of 830°C for 10 hours in an oxygen atmosphere, thereby preparing a positive electrode active material (lithium transition metal oxide) containing 60 mol% or more of nickel and being in the form of a single particle.

### Example 2

A positive electrode active material (lithium transition metal oxide) containing 60 mol% or more of nickel and being in the form of a single particle was prepared in the same manner as in Example 1 except that a temperature in primary sintering was differently set to 930°C.

### Example 3

A positive electrode active material (lithium transition metal oxide) containing 60 mol% or more of nickel and being in the form of a single particle was prepared in the same manner as in Example 1 except that a temperature in primary sintering was differently set to 930°C, and a temperature in secondary sintering was differently set to 850°C.

### Example 4

A positive electrode active material (lithium transition metal oxide) containing 60 mol% or more of nickel and being in the form of a single particle was prepared in the same manner as in Example 1 except that, in primary sintering, a temperature was increased at a heating rate of 7°C/min to perform primary sintering at a sintering temperature of 930°C, and, in secondary sintering, the temperature was increased at the heating rate of 7°C/min to perform secondary sintering at the sintering temperature of 830°C.

### Comparative Example 1

A positive electrode active material precursor [composition: Ni_{0.85}Co_{0.05}Mn_{0.10}(OH)₂, average particle diameter (D₅₀) : 4.0 µm] and LiOH were mixed in a molar ratio of 1:1.05, and a temperature was increased at a heating rate of 5°C/min to perform primary sintering at a temperature of 800°C for 5 hours in the oxygen atmosphere, thereby preparing a pre-sintered product. Then, the pre-sintered product was cooled to room temperature.

The pre-sintered product was ground using the air jet mill, and then the temperature was increased at the heating rate of 5°C/min to perform secondary sintering at a temperature of 400°C for 5 hours in the oxygen atmosphere, thereby preparing a positive electrode active material (lithium transition metal oxide) containing 60 mol% or more of nickel and being in the form of a single particle.

### Comparative Example 2

A positive electrode active material precursor [composition: Ni_{0.85}Co_{0.05}Mn_{0.10}(OH)₂, average particle diameter (D₅₀) : 11.0 µm] and LiOH were mixed in a molar ratio of 1:1.05, and a temperature was increased at the heating rate of 5°C/min to perform primary sintering at a temperature of 830°C for 5 hours in the oxygen atmosphere, thereby preparing a pre-sintered product. Then, the pre-sintered product was cooled to room temperature.

The pre-sintered product was ground using the air jet mill, and then the temperature was increased at the heating rate of 5°C/min to perform secondary sintering at a temperature of 400°C for 5 hours in the oxygen atmosphere, thereby preparing a positive electrode active material (lithium transition metal oxide) containing 60 mol% or more of nickel and being in the form of a single particle.

### Comparative Example 3

A positive electrode active material precursor [composition: Ni_{0.85}Co_{0.05}Mn_{0.10}(OH)₂, average particle diameter (D₅₀) : 4.0 µm] and LiOH were mixed in a molar ratio of 1:1.05, and a temperature was increased at a heating rate of 8°C/min to perform sintering at a temperature of 810°C for 15 hours in the oxygen atmosphere, thereby preparing a positive electrode active material (lithium transition metal oxide) containing 60 mol% or more of nickel and being in the form of a single particle.

### Comparative Example 4

A positive electrode active material precursor [composition: Ni_{0.85}Co_{0.05}Mn_{0.10}(OH)₂, average particle diameter (D₅₀) : 4.0 µm] and LiOH were mixed in a molar ratio of 1:1.04, and a temperature was increased at a heating rate of 8°C/min to perform primary sintering at a temperature of 810°C for 10 hours in the oxygen atmosphere, thereby preparing a pre-sintered product.

The pre-sintered product was ground using an air jet mill, and then 0.01 mol of LiOH was further added. Then, the temperature was increased at the heating rate of 5°C/min to perform secondary sintering at a temperature of 600°C for 10 hours in the oxygen atmosphere, thereby preparing a positive electrode active material (lithium transition metal oxide) containing 60 mol% or more of nickel and being in the form of a single particle.

**[Table 1]**

| | Primary sintering | | | Grinding | Secondary sintering | | |
|---|---|---|---|---|---|---|---|
| | Heating rate (°C/min) | Sintering temperature (°C) | Time (h) | | Heating rate (°C/min) | Sintering temperature (°C) | Time (h) |
| Example 1 | 5 | 910 | 10 | Jet mill | 5 | 830 | 10 |
| Example 2 | 5 | 930 | 10 | Jet mill | 5 | 830 | 10 |
| Example 3 | 5 | 930 | 10 | Jet mill | 5 | 850 | 10 |
| Example 4 | 7 | 930 | 10 | Jet mill | 7 | 830 | 10 |
| Comparative Example 1 | 5 | 800 | 10 | Jet mill | 5 | 400 | 5 |
| Comparative Example 2 | 5 | 830 | 5 | Jet mill | 5 | 400 | 5 |
| Comparative Example 3 | 8 | 810 | 15 | - | - | - | - |
| Comparative Example 4 | 8 | 810 | 10 | Jet mill | 5 | 600 | 10 |

### Experimental Example 1

### 1) SEM image

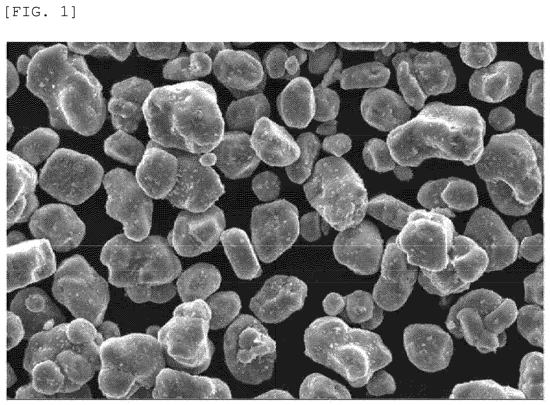

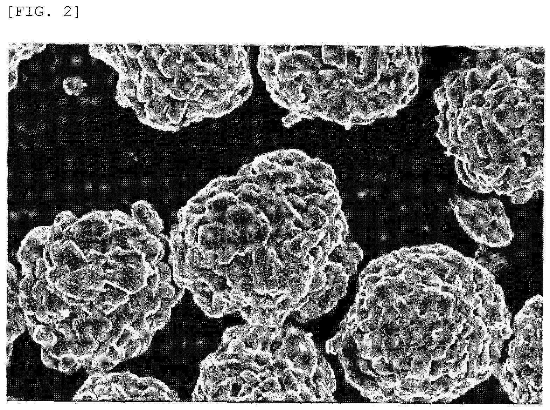

SEM images of the positive electrode active materials prepared Examples and Comparative Examples were obtained using a scanning electron microscope (SEM) (JEOL JSM-7900F). The SEM images of the positive electrode active materials prepared Example 1 and Comparative Example 1 are shown in FIGS. 1 and 2, respectively.

FIG. 1 is the SEM image of the positive electrode active material prepared in Example 1.

FIG. 2 is the SEM image of the positive electrode active material prepared in Comparative Example 1.

2) Particle Size Distribution (PSD) Measurement

### PSD Measurement of Positive Electrode Active Material Particles before Rolling

The positive electrode active material particles prepared in each of Examples and Comparative Examples and 10% aqueous solution (5 mL) of sodium hexametaphosphate as a dispersant were added to 20 mL of deionized water (DI water), followed by 2 minutes of ultrasonic dispersion. Thereafter, PSDs of positive electrode active material particles before rolling were measured using "MICROTRAC S3500" by MICROTRAC, and then the number of 1 µm or less particles based on a total number of the positive electrode active materials was obtained as a percentage (%) value. The obtained values are shown as an amount (%) of 1 µm or less fine power before rolling in Table 2 below.

### PSD Measurement of Positive Electrode Active Material Particles after Rolling

The positive electrode active material prepared in each of Examples and Comparative Examples, a conductive agent (FX35), and a binder (KF9700 and BM73OH were mixed at a weight ratio of 1.35:0.15) were mixed at a weight ratio of 97.5:1:1.5 in an N-methyl-2-pyrrolidone (NMP) solvent to prepare a positive electrode slurry. One surface of an aluminum current collector was coated with the positive electrode slurry, dried at 130°C, and then rolled at a pressure of 6,500 kgf/cm² to manufacture a positive electrode.

The manufactured positive electrode was heat-treated for 2 hours in an air atmosphere at a temperature of 500°C, and then positive electrode active material particles were collected from the positive electrode. Thereafter, the 10% aqueous solution (5 mL) of sodium hexametaphosphate as a dispersant and the positive electrode active material particles were added to 20 mL of deionized water (DI water), followed by 2 minutes of ultrasonic dispersion. PSDs of the positive electrode active material particles after the rolling were measured using "MICROTRAC S3500" by MICROTRAC, and then a volume of 1 µm or less particles based on a total volume of the positive electrode active materials was obtained as a percentage (%) value. The obtained values are shown as an amount (%) of 1 µm or less fine power after rolling in Table 2 below.

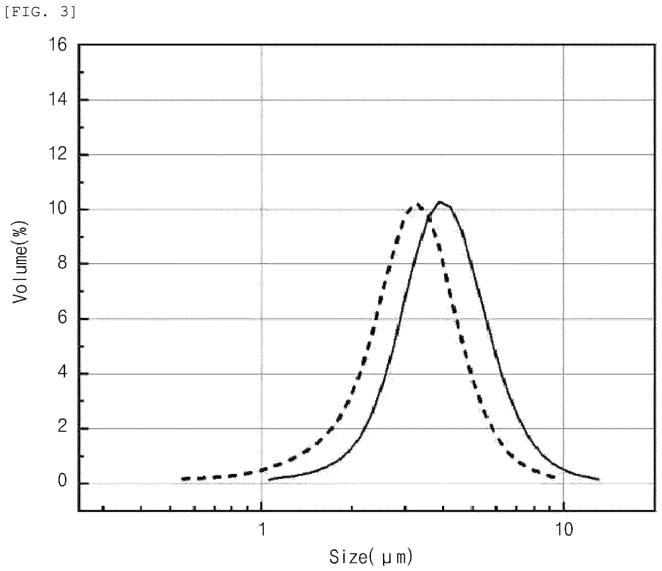

Also, graphs of particle distributions before and after rolling of the positive electrode active materials prepared in Examples 1 to 4 and Comparative Examples 1 to 4 are illustrated in FIGS. 3 to 10, respectively.

FIG. 3 is the graph of the particle distributions before and after the rolling of the positive electrode active material prepared in Example 1.

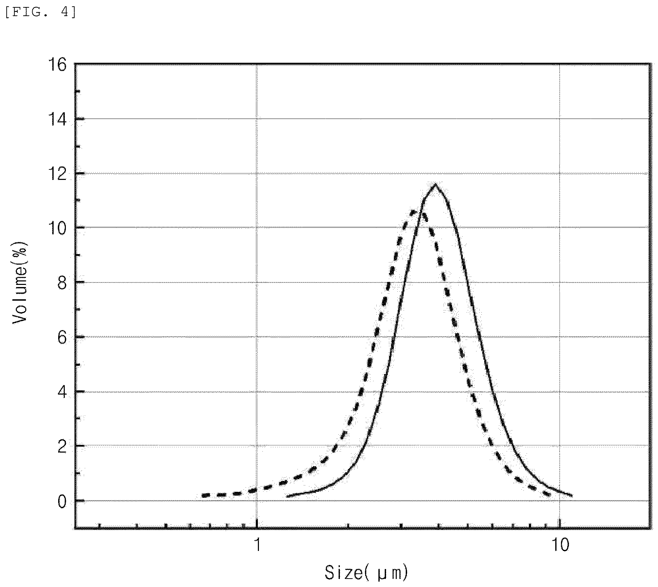

FIG. 4 is the graph of the particle distributions before and after the rolling of the positive electrode active material prepared in Example 2.

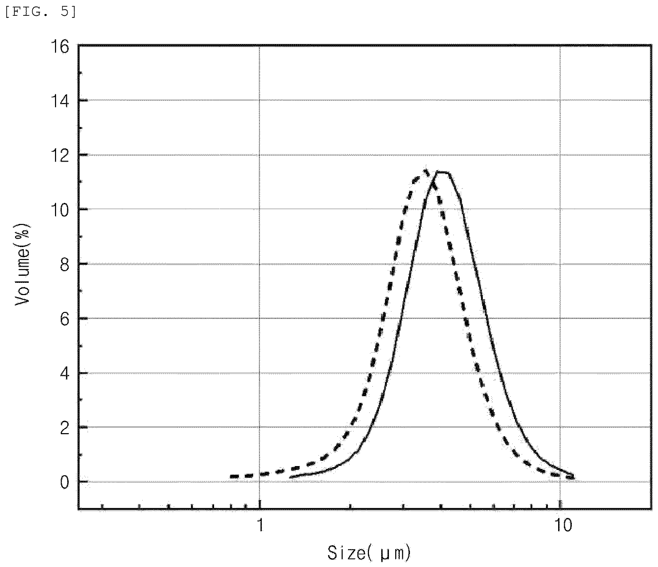

FIG. 5 is the graph of the particle distributions before and after the rolling of the positive electrode active material prepared in Example 3.

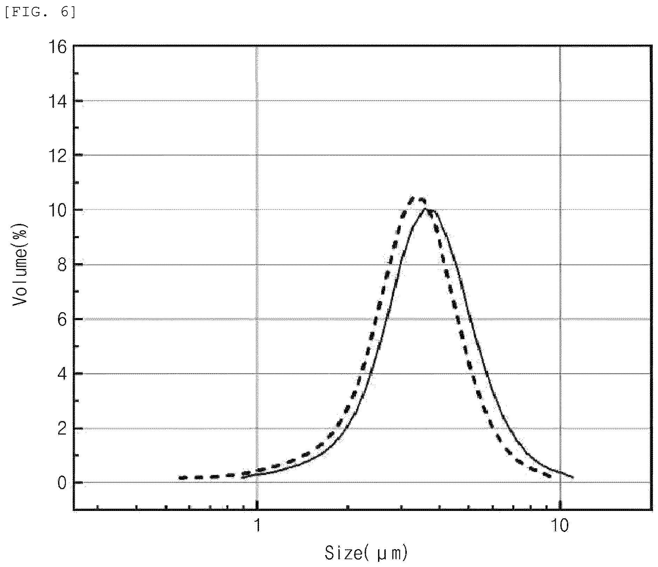

FIG. 6 is the graph of the particle distributions before and after the rolling of the positive electrode active material prepared in Example 4.

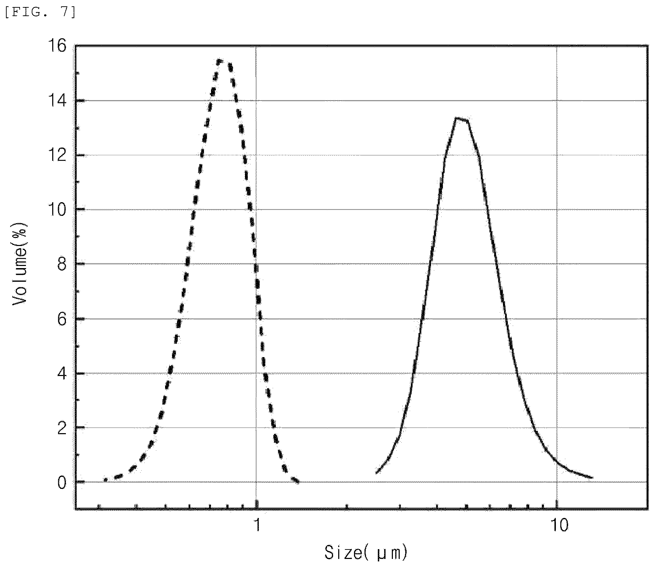

FIG. 7 is the graph of the particle distributions before and after the rolling of the positive electrode active material prepared in Comparative Example 1.

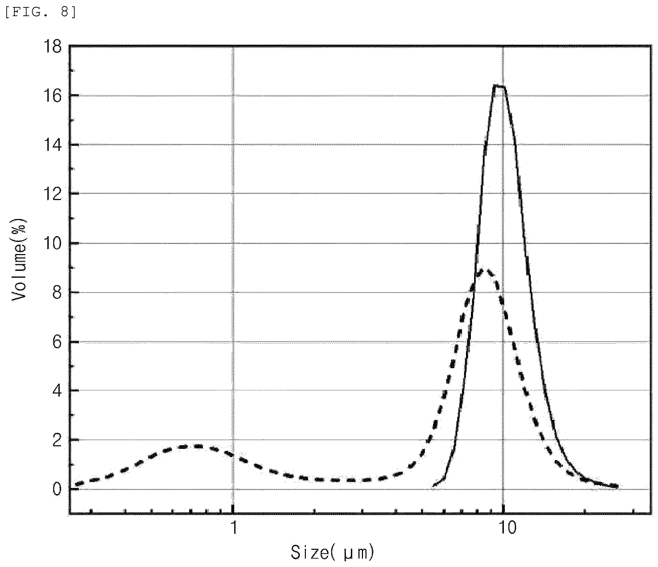

FIG. 8 is the graph of the particle distributions before and after the rolling of the positive electrode active material prepared in Comparative Example 2.

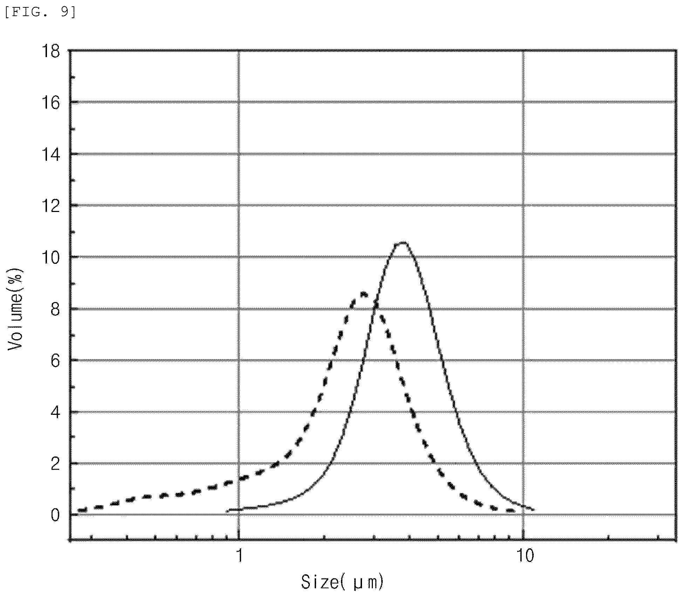

FIG. 9 is the graph of the particle distributions before and after the rolling of the positive electrode active material prepared in Comparative Example 3.

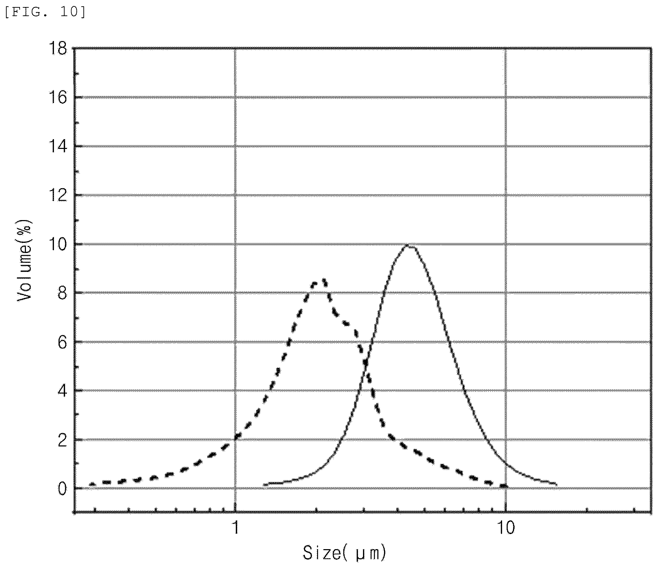

FIG. 10 is the graph of the particle distributions before and after the rolling of the positive electrode active material prepared in Comparative Example 4.

### Experimental Example 2

### Life Characteristics Evaluation

A lithium secondary battery was manufactured using each of the positive electrodes manufactured in Experimental Example 1, and life characteristics of each of the lithium secondary batteries was evaluated.

Here, a lithium (Li) metal disk was used as a negative electrode, and an electrode assembly was manufactured by interposing a separator between the positive electrode and the negative electrode. Then, the electrode assembly was disposed inside a battery case, and then an electrolyte solution was injected into the battery case to manufacture the lithium secondary battery. Here, an electrolyte solution, obtained by dissolving 1 M of LiPF₆ in an organic solvent in which ethylene carbonate:ethyl methyl carbonate:dimethyl carbonate were mixed in a volume ratio of 3:3:4, was used as the electrolyte solution.

Subsequently, each of the manufactured lithium secondary batteries was charged at a constant current of 0.1 C to 4.25 V in a constant current/constant voltage (CC/CV) mode at 25°C (CV 0.05 C), and then discharged to 3.0 V in a CC mode to measure 1st cycle initial charge capacity and discharge capacity.

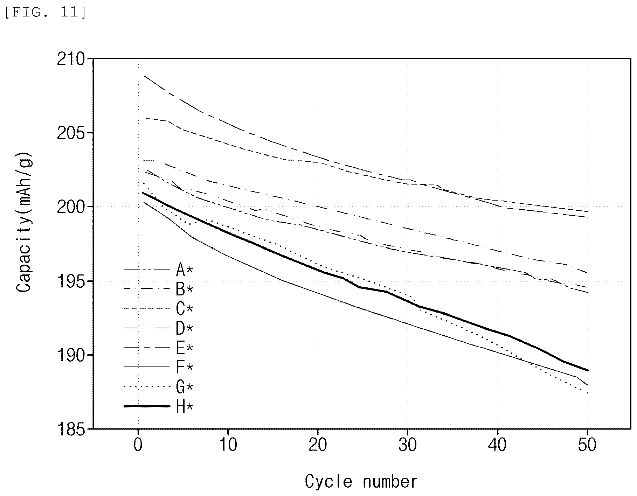

Also, charging to 4.25 V in a range of 3.0 V to 4.25 V at 45°C in a CC-CV mode (CV 0.05C) and then discharging to 3.0 V in a CC mode was set to one cycle, and the cycle was repeated 50 times to measure capacity retention (discharge capacity in the 50th cycle/initial discharge capacity×100) in the 50th cycle of each of the lithium secondary batteries. Measurement results are shown in FIG. 11 and Table 2 below.

FIG. 11 is a graph of cycle-based capacities (mAh/g) of secondary batteries including the positive electrode active materials prepared in Examples and Comparative Examples. Specifically, A* represents data for Example 1, B* represents data for Example 2, C* represents data for Example 3, D* represents data for Example 4, E* represents data for Comparative Example 1, F* represents data for Comparative Example 2, G* represents data for Comparative Example 3, and H* represents data for Comparative Example 4.

**[Table 2]**

| | Amount of 1 | Amount of 1 | Initial | Initial | Capacity |
|---|---|---|---|---|---|
| | µm or less fine power before rolling (%) | µm or less fine power after rolling (%) | charge capacity (25 °C) (mAh/g) | discharge capacity (25 °C) (mAh/g) | retention (50 cycles) (%) |
| Example 1 | 0 | 2.05 | 229.2 | 202.3 | 96.1 |
| Example 2 | 0 | 1.46 | 230.6 | 203.1 | 96.2 |
| Example 3 | 0 | 0.76 | 232.4 | 206.1 | 96.6 |
| Example 4 | 0.46 | 1.93 | 229.3 | 202.1 | 96.2 |
| Comparative Example 1 | 0 | 93.79 | 222.3 | 200.1 | 94.8 |
| Comparative Example 2 | 0 | 18.16 | 230.1 | 208.5 | 95.1 |
| Comparative Example 3 | 0.59 | 11.39 | 228.9 | 201.4 | 93.3 |
| Comparative Example 4 | 0 | 10.71 | 228.4 | 200.9 | 94.1 |

As may be confirmed in Table 2 above, in the positive electrode active materials prepared in Examples 1 to 4, when the pressure of 6,500 kgf/cm² was applied to the positive electrode active material, the amount of fine powder having a particle diameter of 1 µm or less was confirmed to be 10 vol% or less based on the total volume of the positive electrode active material after the applying the pressure. In contrast, it was confirmed that in the positive electrode active materials prepared in Comparative Examples 1 to 4, when the pressure of 6,500 kgf/cm² was applied to the positive electrode active material, the amount of fine powder having a particle diameter of 1 µm or less was more than 10 vol% based on the total volume of the positive electrode active material after the applying the pressure. It was confirmed that the secondary batteries including the positive electrode active materials prepared in Examples 1 to 4 had excellent capacity retentions compared to the secondary batteries including the positive electrode active materials prepared in Comparative Examples 1 to 4. And it was confirmed that, in the secondary batteries including the positive electrode active materials prepared in Examples 1 to 4, the initial charge capacity was 229.2 mAh/g or more, and the initial discharge capacity was 202.1 mAh/g or more.

## Claims

1. A positive electrode active material comprising:
a lithium transition metal oxide in a form of a single particle,
wherein the lithium transition metal oxide contains 60 mol% or more of nickel among total transition metals,
wherein, when a pressure of 6,500 kgf/cm² is applied to the positive electrode active material, an amount of fine powder having a particle diameter of 1 µm or less is 10 vol% or less based on a total volume of the positive electrode active material after the applying the pressure.

2. The positive electrode active material of claim 1, wherein the positive electrode active material has an average particle diameter (D₅₀) of 2 µm to 12 µm.

3. The positive electrode active material of claim 1, wherein the positive electrode active material has a particle strength of 500 Mpa to 1,500 Mpa,
wherein the particle strength (MPa) is a value which is obtained by collecting a sample of lithium transition metal oxide particles, placing the collected sample on glass, and then measuring a force until the particles break and a tip touches the glass on which the sample has been placed while applying a pressure of 100 mN to the sample with the tip.

4. The positive electrode active material of claim 1, wherein the positive electrode active material has a composition represented by Formula 1 below:
[Formula 1] LiₐNiₓCo_{y}M¹_{z}M²_{1-x-y-z}O₂
wherein, in Formula 1,
M¹ is at least one selected from the group consisting of manganese (Mn) and aluminum (Al),
M² is at least one selected from the group consisting of boron (B), barium (Ba), cerium (Ce), chromium (Cr), fluorine (F), magnesium (Mg), vanadium (V), titanium (Ti), iron (Fe), zirconium (Zr), zinc (Zn), silicon (Si), yttrium (Y), niobium (Nb), gallium (Ga), tin (Sn), molybdenum (Mo), tungsten (W), phosphorus (P), sulfur (S), strontium (Sr), tantalum (Ta), lanthanum (La), and hafnium (Hf), and
1.0≤a≤1.3, 0.6≤x<1.0, 0<y<0.4, 0<z<0.4, and 0≤1-x-y-z ≤0.4.

5. The positive electrode active material of claim 1, wherein an amount of fine powder having a particle diameter of 1 µm or less before rolling is 0% to 1% based on a total number of the positive electrode active material.

6. A method for preparing a positive electrode active material, the method comprising steps of:
1) preparing a pre-sintered product by mixing a positive electrode active material precursor containing 60 mol% or more of nickel among total transition metals, and a lithium-containing raw material, and increasing a temperature to a primary sintering temperature to perform primary sintering;
2) cooling the pre-sintered product to room temperature; and
3) preparing a lithium transition metal oxide in a form of a single particle by mixing the pre-sintered product and the lithium-containing raw material, and increasing the temperature to a secondary sintering temperature to perform secondary sintering,
wherein the primary sintering temperature is 850°C to 950°C, the secondary sintering temperature is 800°C to 850°C, and the secondary sintering temperature is lower than the primary sintering temperature.

7. The method of claim 6, wherein a heating rate in step 1) and a heating rate in step 3) are each 4 °C/min to 7 °C/min.

8. The method of claim 6, further comprising a step of 2-1) grinding the pre-sintered product before the secondary sintering is performed in step 3).

9. The method of claim 6, further comprising a step of 3-1) grinding the secondary sintered product.

10. A positive electrode comprising the positive electrode active material of any one of claims 1 to 5.

11. A lithium secondary battery comprising:
the positive electrode of claim 10;
a negative electrode;
a separator interposed between the positive electrode and the negative electrode; and
an electrolyte.
